Europäisches Patentamt

European Patent Office

Office européen des brevets

(19)

(11) Publication number : **0 648 858 A1**

## (12) EUROPEAN PATENT APPLICATION

(21) Application number : **94307139.9**

(22) Date of filing : **29.09.94**

(51) Int. Cl.⁶ : **C23C 16/26,** C23F 4/00,
      H01L 21/00

(30) Priority : **15.10.93 US 138518**

(43) Date of publication of application :
**19.04.95 Bulletin 95/16**

(84) Designated Contracting States :
**DE FR GB NL**

(71) Applicant : **APPLIED MATERIALS, INC.**
**3050 Bowers Avenue**
**Santa Clara California 95054-3299 (US)**

(72) Inventor : **Shamouillian, Shamouil**
**1256 Washoe Drive**
**San Jose, CA 95120 (US)**
Inventor : **Ye, Yan**
**3862 Via Salice**
**Campbell, CA 95008 (US)**

(74) Representative : **Bayliss, Geoffrey Cyril et al**
**BOULT, WADE & TENNANT**
**27 Furnival Street**
**London EC4A 1PQ (GB)**

(54) Methods of coating plasma etch chambers and apparatus for plasma etching workpieces.

(57) The disclosure relates to a method of protecting a semiconductor workpiece (129) from contact with free-floating particulate contamination during plasma etching of the workpiece. Gaseous materials which are capable of forming a polymeric coating upon exposure to a plasma are used to generate films of polymeric coating (122) which trap particulate contaminants against the etch chamber walls (113), making these contaminants unavailable to contaminate the workpiece surface. Preferred materials include certain halocarbon gases.

FIG. 1

EP 0 648 858 A1

This invention relates to a method of controlling particulate contamination of a semiconductor workpiece surface/substrate during processing which employs plasma etching.

As the geometries of semiconductor devices become ever so smaller, the ability to maintain the uniformity and accuracy of critical dimensions becomes strained. Many of the processes carried out within semiconductor processing reactors leave contaminant deposits on the walls of the process chamber which accumulate and become the source of particulate matter harmful to the creation of a semiconductor device. As the dimensional size of the semiconductor device has become ever smaller, the presence of particulate matter upon the surface of the semiconductor workpiece has become ever more critical.

Particulate contamination buildup on semiconductor process chamber walls has long been a major problem in the etch processing of semiconductor elements employing metal films. These metal films are generally etched by employing a number of reactive gases, including halocarbon gases, as plasma components. In the case of an aluminum film, the etchant gases used are predominantly the chlorine containing gases, chlorine ($Cl_2$) and boron trichloride ($BCl_3$), which enables formation of volatile aluminum chloride compounds upon etching, which volatile compounds can be removed from the etch processing chamber by applied vacuum. However, simultaneously with the formation of volatile aluminum chloride compounds, other active chlorine and boron containing species are formed which can react with any oxygen and water vapor present in the etch processing chamber or with organic species from patterning photoresist to form non volatile particulate compositions which ultimately produce relatively large quantities of contaminant on the process chamber inner walls. The non volatile particulate compositions initially tend to remain inside the etch chamber in the form of loosely attached particles to the chamber etch surfaces. The loosely attached compounds can easily break free of the surface to which they are attached, and fall upon a workpiece/ substrate surface, causing contamination of the workpiece surface and resulting in a defective device. Further, as time progresses, the non volatile compositions combine with polymeric materials generated from photoresist and carbon-containing etchant gases (by products of the etch process) and accumulate to form a contaminant deposit on the etch process chamber surfaces. As the thickness of this contaminant deposit increases, stability of the deposit decreases due to its weight and this eventually results in excessive particulate flaking or powdering. The powder or flakes drop off and float or are propelled within the etch processing chamber, thereby causing contamination of the semiconductor workpiece/ substrate.

Removal of contaminants from the walls of etch processing chambers has been accomplished by periodically cleaning plasma etch chambers including the gas distribution plates. Known cleaning methods have involved opening the plasma etch chamber, disassembling portions of the chamber, and removing the contaminant deposits by physical of chemical methods. For example, the chamber can be rinsed with a solution of hydrochloric acid, or hand wiped with a solvent, to dissolve various contaminants. The etch chamber alternatively may be washed with water and dried. All of these cleaning methods are complicated, disruptive, time consuming and can be the source of additional contamination.

Plasma enhanced dry cleaning processes exist whereby contaminants attached to the inside walls of a film deposition reaction chamber are removed by plasma etching using carbon tetrachloride and oxygen. However, presently known plasma enhanced dry cleaning systems require a dry cleaning time period equal to about 5% to 10% of the time spent in the aluminum etching process itself.

The present invention provides a method for controlling contaminant buildup on semiconductor plasma processing chambers and reducing the amount of time required for cleaning the plasma chamber. The instant contamination control development extends the periods of required chamber contaminant removal and particularly improves the efficiency of metal etch plasma processes, since these processes exhibit one of the highest contaminant accumulation rates.

U.S. Patent No. 5,087,727 to R.J. Steger, issued February 4, 1992, discloses an improved plasma etching apparatus comprising an etch chamber having inner metal surfaces coated with a conductive coating capable of protecting such inner metal surfaces from chemical attack by reactant gases such as halogen-containing gases used in the chamber during the plasma etching process. In a preferred embodiment, a carbon coating at least about 0.2 micrometers is formed on the inner metal surfaces of the etch chamber by a plasma assisted CVD process using a gaseous source of carbon and either hydrogen or nitrogen or both. The conductive coating is described as comprising a material selected from the group consisting of carbon, titanium nitride, indium stannate, silicon carbide, titanium carbide and tantalum carbide. However, there is no disclosure of contamination control as contemplated in the instant invention.

U.S. Patent 4,372,807 to Vossen et al., discloses a process of plasma etching of aluminum in which the hydrocarbon gases, cyclopropane and ethylene, are added to the etchant gases and polymerized on the sidewalls of the etched aluminum to effect sidewall passivation thereby reducing undercutting and improving etch uniformity. The patent is silent as to any deposition of hydrocarbon polymer on the reactor walls or contamination control.

2

U.S. Patent 4,786,359 to Stark et al., issued November 22, 1988, describes a plasma etch process and apparatus in which silicon wafers are etched using a plasma assisted gas mixture comprising $CF_3Br$ and xenon or krypton. The patent teaches that the use of this halocarbon etchant gas results in polymer film deposition in the plasma reactor and cites such formation as a negative factor in the plasma etching process because of changes in the electrical characteristics of the reactor chamber and the presence of the polymer deposit as a source of particle contamination for the target wafer. The patent describes a means of preventing or eliminating buildup of the polymer by the use of oxygen in the etchant gas mixture and a sacrifical graphite ring.

Descriptions of the interrelationship between plasma etching and plasma polymerization, with emphasis on the plasma-surface interactions leading to polymerization are presented in "Plasma Polymerization of Fluorocarbons in RF Capacitively Coupled Diode System" by E. Kay and A. Dilks, J. Vac. Sci. Technol. 18 (1) Jan./Feb. 1981. Further description of the use of fluorine or chlorine containing gases in plasma etching is provided in "Today's Plasma Etch Chemistries", Peter H. Singer, Semiconductor International, March 1988. These articles highlight that the development of a successful etch chemistry requires a careful selection of input gas composition as well as careful control of the process variables, including gas flow rate, chamber pressure and temperature, plasma energy and system configuration. Typically, the etch process must be tailored to the particular material to be etched (with process parameters being adjusted within predictable ranges in view of the particular system configuration).

All of the cited prior art describe the film-forming use of carbon-containing materials in gas plasma reactions to: (a) polymerize on the side walls of etched aluminum under glow discharge conditions, thereby preventing the undercutting of aluminum side walls during aluminum plasma etching; and (b) provide a protective coating on the walls of plasma chambers which protects those chamber walls from attack by halogen containing gases during plasma etching processes. While it is apparent that carbon-containing materials react under plasma glow discharge conditions to form oligomers, polymers and other chemical compounds, there has been no attempt heretofore to utilize the polymer formation capabilities of organic materials under plasma glow conditions to control the significant contaminant buildup on the walls of plasma etch process chambers.

The present invention is based on the discovery that organic materials typically used in etching environments have high polymer forming activity when exposed to a plasma environment and that this polymer formation activity can be manipulated and exploited to cause film formation on etch chamber walls to cover and entrap loosely bound etch by-products deposited on these walls. Further, that by manipulation of particular plasma glow discharge process variables, this polymer forming activity can be enhanced to form a strong and adherent interpenetrating coating network about a plasma etch chamber wall surface and thereby entrap and cover any loosely bound etch by-products with a strong plasma resistant polymer film coating.

The instant plasma film generation process can be alternatively practiced solely in connection with an unused chamber or concurrently and in combination with the etch processing of a workpiece whereby plasma etch generated particulate contaminants are continuously encapsulated and entrapped in the polymer coating formed on the plasma chamber walls. The film generated must form on the walls of the etch chamber in sufficient quantity to form an interpenetrating network of polymer film so as to trap and encapsulate free floating or loosely attached particulate contaminants securely against the etch chamber walls. Although it is necessary to periodically clean the film/contaminant buildup off the etch chamber walls, the present invention enables a contaminant-laden chamber to be cleaned less frequently since the polymeric film network has eliminated the danger of loosely attached particulates flaking off the chamber walls during subsequent etch processing. In summary, the practice of the instant plasma film generation process results in an interpenetrating film covering which controls the particulate contaminant etch by-products thereby reducing the chamber down time for cleaning and improving overall semiconductor processing efficiency.

The instant invention is directed to a method for controlling contaminant buildup on the inner walls of a plasma etch chamber by intermittently or continuously forming a coating of a polymeric film thereon, thereby reducing the possibility of contamination of the semiconductor workpiece by floating or flaking particulate contamination. The instant contamination control process may be practiced independently of the etching process as follows:

A method for coating a plasma etch chamber to secure plasma generated particulate by-products to the chamber wall comprising:

a) providing a plasma etch chamber having a workpiece pedestal and plasma generated particulate residues attached to the inner walls thereof;

b) communicating into the chamber at least one- carbon containing material which volatilizes under plasma glow discharge conditions;

c) activating a plasma within the plasma etch chamber; and

d) maintaining the chamber at a pressure between 100 to 700 mTorr and the temperature of the workpiece pedestal higher than the chamber walls for a sufficient period to cause polymerization of the carbon containing material and deposition of a surface coating of the inner walls of the chamber in a layer having a thickness of at least 0.1 micrometer (1,000 Angstroms) whereby an interpenetrating network of polymer film is formed about the accumulated contaminant particles thereby entrapping the particulate contaminants and rendering the plasma chamber contaminant free for further etch processing use.

Alternatively, contamination control and etching of a workpiece may take place concurrently as follows:

A method for controlling plasma generated particulate by-product buildup on the inner walls of a plasma reaction chamber during the plasma etching of a metallic film workpiece comprising the steps of:

a) providing a plasma etch chamber;

b) communicating into said chamber at least one etchant gas and at least one carbon containing gas;

c) activating a plasma within the plasma etch chamber; and

d) manipulating the plasma process conditions so as to effect concurrent and continuous etching of the workpiece and film formation on the inner walls of the chamber whereby an interpenetrating network of polymer film entraps and encapsulates plasma generated particulate contaminants to secure them to the inner wall surface.

The present invention is further directed to an apparatus comprising a plasma etch chamber having a coating of the instant plasma generated halocarbon polymer film upon the walls thereof, wherein the polymer film coating is firmly attached to the plasma etch chamber wall; the halocarbon polymer film coating has sufficient mechanical strength to prevent flaking; and the polymer film coating has the capability of attracting free floating or directed particulate matter to the walls of the etch chamber under plasma etching conditions.

The following is a description of some specific embodiments of the invention reference being made to the accompanying drawings, in which:

FIG. 1 is a schematic of a vertical cross section of a typical plasma etching system configuration demonstrating the protective and adherent halocarbon coating of the present invention.

FIG. 2 is a partial sectional view of a coated plasma chamber demonstrating the attraction to and trapping of particulate matter at the plasma chamber wall during plasma etch processing.

The present invention is directed to a method and apparatus useful for the control of contaminant particles in the plasma processing of semiconductor workpieces. The invention is particularly useful in controlling contaminants generated in the plasma etch of metallic workpieces. The process is described in the following preferred embodiments in terms of the entrapment and control of organo-metallic contaminants and particularly organo-metallic materials comprising aluminum and compounds thereof. However, the concept of employing a carbonaceous film-forming material in a plasma glow discharge process for purposes of entrapping plasma generated by-products and adhering them to the plasma chamber wall is applicable to semiconductor process chambers in general. For example, contaminant control is important for chambers used for chemical vapor deposition, physical vapor deposition, epitaxial growth, and dopant implantation as well as chambers used in metal etching.

The instant film generation process can be carried out under typical plasma glow discharge process conditions, to achieve high activity polymerization of the carbon containing material, wherein a uniform thin film coating of polymer having good mechanical strength is formed upon plasma chamber walls. Preferably, the chamber walls are maintained at a lower temperature than that of the workpiece pedestal which enhances film formation on the chamber walls while rendering film formation on the workpiece pedestal less likely. This temperature differential is particularly important when an etching process is carried out concurrently with film formation.

The plasma process variables of (a) plasma gas mixture composition and flow rate, (b) the chamber pressure, (c) chamber wall temperature, (d) the workpiece pedestal temperature, and (e) the plasma power density can be selected to achieve a polymeric coating having the desired characteristics of good mechanical strength and high surface adhesion so as to form a stable and interpenetrating polymer film network about the contaminant laden chamber wall surface. This new plasma generated polymer coating exhibits strong adhesion to the surface of the etch chamber wall and possesses the strength to trap and encapsulate the particulates which are loosely attached to the walls of the chamber. In the event film formation is carried out concurrently with an etch process, the newly formed film will ensnare any free floating particulate etch by-products and entrap them in the interpenetrating film network coating.

As indicated above, the use of any carbon-containing material in the present plasma contaminant control coating process will be effective provided such material (eg. photoresist) volatizes and polymerizes under plasma glow conditions. In the case where the carbon-containing material is an organic gas, it may be one of the etchant gases and thereby function in the dual role of etchant and film forming material. Preferred organic materials for use in the instant process are those which form polymeric film coatings under plasma glow discharge conditions and which are hydrophobic and exhibit minimal swelling under plasma etch chamber operational conditions. These characteristics, combined with good film mechanical strength, enable these film coatings

4

to effectively entrap particulate etch by-product contaminants and to be plasma resistant during the plasma etch process. While the film forming nature of several of certain halocarbon etch gases and carbon-containing gases has been generally known, it has not heretofore been recognized that appropriate manipulation of plasma process variables can: (1) provide an environment for reducing molecular fragmentation and rearrangement of precursor organic molecules; (2) enhance the copolymerization of the monomeric organic molecules with inorganic etch-generated reactive species; and, (3) direct the formation of a polymeric coating to the etch by-product laden walls of a plasma etch chamber where the loosely held particulate contaminants are trapped (and fixedly segregated from the semiconductor workpiece).

Preferably any film-forming gas used in the practice of the present invention is a carbon-comprising gas such as an alkane gas such as methane, ethane, propane, or butane; an alkene gas such ethylene or propylene; or a halocarbon gas. Most preferably, the coating forming gas is a halocarbon gas selected from the group consisting of trichloromethane ($CHCl_3$), tetrafluoromethane ($CF_4$), difluoromethane ($CH_2F_2$), trifluoromethane ($CHF_3$), tetrafluoroethylene ($C_2F_4$), perfluoropropane ($C_3F_8$), and chlorotrifluoromethane ($ClCF_3$). These halocarbon gases produce novel strongly adherent polymer coatings the surfaces of which have an attraction or sticking quality for solid particles circulating in the chamber. Halocarbon polymers having excessive halogen content would have non-stick (i.e. Teflon) characteristics and be less effective as polymeric coatings in the present invention.

Typical plasma assisted aluminum etch chemistry utilizes process gases including $BCl_3$, $Cl_2$, and $N_2$ as an example. During a chlorine-based aluminum etch process, aluminum on the substrate reacts with chlorine atoms and possibly with chlorine containing molecules to form volatile aluminum chloride molecular species. Some of this etch byproduct is pumped out of the chamber, while some reacts with or associates with organic species from patterning photoresists of with other reactive species in the process chamber to form non-volatile particulate materials, many of which are loosely deposited as potential contaminants on the process chamber wall surfaces. The present invention is directed to the control of such contaminants.

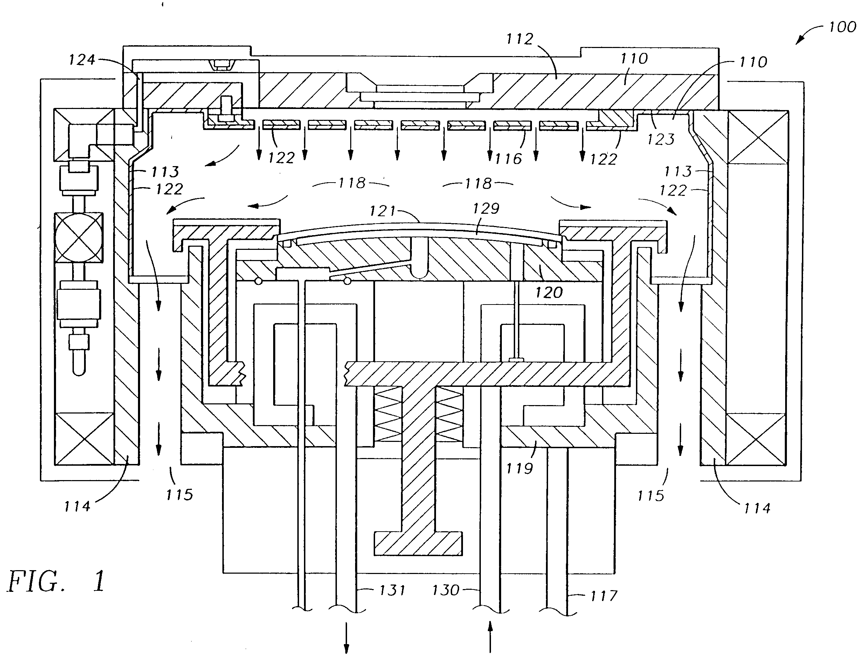

FIG. 1 demonstrates a conventional parallel plate etching apparatus 100 which includes a closed metal, generally aluminum, plasma etch chamber 110 comprising a top lid 112, sidewalls 113 and a chamber housing 114 having a connection 115 to an exhaust vacuum pump (not shown) for partial evacuation of chamber 110. Etchant and polymeric coating forming gases of the present invention enter chamber 110 through a gas distribution plate 116 which is supplied with gases via a valved inlet system. The apparatus further includes an RF power supply source 117 which works in combination with a cathode which serves as a workpiece support pedestal 120 and with chamber wall 119, chamber housing 114, chamber lid 112, and gas distribution plate 116 which all serve as a grounded anode. A workpiece, 121 is mounted on pedestal 120, which is shielded from (not shown) and separated from grounded anode chamber wall 119. The plasma etch system is configured in a manner to draw gases between gas distribution plate 116 and pedestal 120 in a manner which typically confines the reactant gas plasma in the general area of workpiece 121. However, by adjusting etch process operating variables, it is possible to cause the formation of a polymeric coating on plasma chamber walls while achieving etching at the surface of workpiece 121.

In Figure 1 a plasma is generated in area 118 of plasma chamber 110 by the action of an RF charge entering the etch chamber 110 at location 121. The outer boundaries of plasma area 118 depend on the operating parameters of etch chamber 100. The etch gases exit plasma chamber 110 through conduits 115 in response to an applied vacuum (not shown). Substrate 129 can be heated and cooled during processing. Substrate 129 is heated by heating substrate support platform 120 and passing a heat conducting inert gas between the lower surface substrate 129 and the upper surface 121 of support platform 120. Substrate 129 can be cooled by passing cooling water through conduits adjacent support platform 120, where the water enters through conduit 130 and exits through conduit 131. Power supply 117 biases cathode pedestal 120 with respect to the grounded anode comprising chamber wall 119, chamber housing 114, chamber lid 112, and gas distribution plate 116 to generate the electric field necessary to ionize the gases contained in etch chamber 110.

In accordance with the present invention, a coating 122 of an interpenetrating network of polymer is formed on the inner walls 113 of chamber housing 114, on the inner surface 123 of lid 112, and on the surface of gas distribution plate 116 which coating 122 covers and entraps particulate contaminants deposited on inner walls 113. This coating of particulate trapping polymeric material has superior bonding and adhesion to the metallic walls of plasma etch chamber 110 and covers the particulate contaminants which form loose deposits on the inner chamber walls 113 during plasma etch processing. The particle-trapping coating of polymeric material increases with layer thickness as plasma generated film deposition time is extended or repeated, until such time as it is desirable to clean the chamber 110 or remove the coating 122 and trapped contaminants. It is preferable that an initial coating, having a thickness of at least about 0.1 micrometer (1,000 Angstroms), be deposited on the inner surfaces of etch chamber 110 prior to the commencement of any plasma etch processing so as to protect the wall itself from the corrosive effect of both the etchant gases and particulate contaminants.

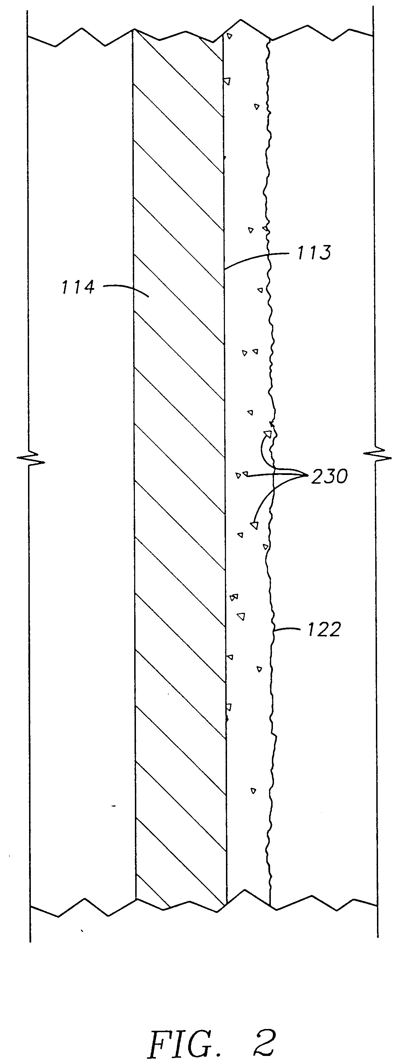

A schematic segment of the plasma etch chamber wall having a particulate-trapping coating upon its surface is shown in FIG. 2. With- reference to FIGS. 1 and 2, the particulate-trapping polymeric coating 122 bonds firmly to the inner wall surface 113 of chamber housing 114, and compositionally consists of an organic/inorganic polymer comprised of organic chains and inorganic moieties having a physical structure which is hard and strongly adherent to the chamber walls. The exact chemistry of the polymer is unpredictable due to the nature of plasma discharge polymerization; that is, composition of the polymer is likely to change somewhat as plasma process conditions are changed during the etching of any workpiece. Trapped contaminant particles 230 are sealed and locked in place within the coating and unavailable to contaminate the surface of workpiece 121. As demonstrated in FIG. 2, contaminant particles 230 are shown as entrapped randomly in the polymer film layer 122 to dramatically demonstrate the interpenetrating and encapsulating nature of the polymer film coating 122 about particules 230. In actual practice, particules 230 would likely be in deposited clusters on the chamber wall surfaces 113 or subsequent surfaces 122 created by intermittent or continuous polymer film formation.

The polymeric coating of the present invention is prepared by plasma reaction of carbon-containing materials which include solids such as organic photoresist elements and organic alkane and alkene gases such as methane, ethane, propane, butane, ethylene, propylene, and organohalocarbon gases. Preferred carbon-containing gases include halocarbons selected from the group comprising trichloromethane ($CHCl_3$), tetrafluoromethane ($CF_4$), difluoromethane ($CH_2F_2$), trifluoromethane ($CHF_3$), tetrafluoroethylene ($C_2F_4$), perfluoropropane ($C_3F_8$), and chlorotrifluoromethane ($ClCF_3$). Plasma generated polymer films (shown in FIGS. 1 and 2 as 122) prepared from these halogenated compounds, when applied to the inner surfaces of plasma etch chamber 110, will form a firmly bonded film coating having good mechanical strength and capable of attracting particulate contaminants to the polymeric coating surface under plasma etch conditions.

The instant invention is further directed to the manipulation and control of the etch process parameters to concurrently achieve the etching of a workpiece and the preparation of the particulate contaminant trapping coating herein described. To this end, the plasma etch process variables subject to control and manipulation include (1) the composition of each input gas; (2) the relative amounts of each input gas; (3) the overall gas mixture flow rate; (4) etch chamber pressure; (5) etch chamber wall (interior surfaces) temperature; (6) workpiece pedestal temperature; and (7) plasma energy density. Typically the system configuration is designed in view of overall plasma etching requirements, and variables (1) - (7) are adjusted within the constraints of the system configuration.

As indicated the instant plasma process of contaminant-entrapping film formation can be conducted intermittently between etch runs resulting in independant film formation in the chamber or concurrently with the ongoing etch processing of a metallic workpiece resulting in the in situ formation of a particulate contaminant entrapping coating. In a metallic workpiece etch process where in situ formation of the instant contaminant entrapping film coating is performed, control of the plasma etch process conditions and parameters listed above is important in achieving the polymer coating characteristics herein described. Moreover, control of the etch process is further important in avoiding excessive buildup of polymer on the chamber walls and contamination of the chamber workpiece. As disclosed herein, by careful manipulation and control of an etch process configuration and conditions, polymer formation is concurrent and ongoing with a metallic workpiece etch process thereby entraining the plasma generated particulate contaminants and entrapping them in the strong adhesive coating on the inner walls of the chamber. Reference to Figure 2 indicates this phenomena in that the nature of the swirling plasma atmosphere will entrain the plasma-generated etch by-product particles 230 onto the surface of the coating layer 122 where they will be entrapped and sealed in coating layer 122. Additionally, the instant plasma generated contaminant entrapping coatings will have sticking characteristics upon formation which draw and adhere the plasma generated contaminant particles to the surface thereof during a concurrent etch and polymer formation process.

In operation, there may be several different supply tanks for the various etchant and coating-forming gases to be supplied to the plasma etch chamber. The gas flow rates are set to the desired relative amounts and gas mixture flow rate, and the gas mixture is fed into gas distribution supply line 124 shown in FIG. 1. As previously described, it is possible for a single gas to be both a film forming gas and an etchant gas. Some gases such as $Cl_2$ and $BCl_3$, while not being coating-forming gases individually, can react with the carbon containing gases to become part of the coating forming process. The coating-forming gases and etchant gases are typically mixed with inert gases such as helium and argon. Other potentially reactive gases such as oxygen and nitrogen can be added to promote formation of the desired polymeric coating. In a preferred embodiment, the film forming gases of the present invention should be in a ratio with the other gases in the plasma chamber of about 60% to 40% by volume to effect film deposition under standard plasma glow discharge conditions.

During the etching process, the exhaust pump is actuated to substantially evacuate chamber 110. The gas supply valves are opened to permit a predetermined mixture of etchant gas(es) and coating-forming gas(es) to enter chamber 110. Preferably, the coating-forming gases should include not only the carbon-containing gases which are basic film-formers, but also additive inorganic materials, which provide inorganic species which copolymerize with the carbon containing gases to render the desired qualities in the particle trapping coating. Examples, not by way of limitation, of such additive materials include the oxygen, nitrogen, and boron-containing gases cited above. Nitrogen ($N_2$) has been found to be a preferred inorganic gas additive to enhance film formation and the presence or absence of $N_2$ is a compositional choice in the plasma process to achieve desired results; e.g. adding Nitrogen ($N_2$) to enhance film formation in an etching process. The overall gas mixture flow rate typically ranges between about 100 sccm to about 200 sccm.

Within the purview of the present invention, operational etch process and plasma film deposition parameters are as follows. The etch chamber process pressure should be below 700 mTorr and preferably range between about 30 to about 500 millitorr. The etch chamber wall (interior surfaces) temperature should be lower, at least 5°C lower, in temperature than the workpiece temperature to enhance polymer deposition on the chamber wall surface. The workpiece temperature will be the operational temperature of the chamber and should range from about 60°C to about 100°C. The plasma energy density applied to the chamber should range from about 300 to about 800 W. In an etching process, the exposure time for coating formation will be the same exposure period for the etch process. When a coating is applied prior to the initiation of the etch process, the exposure time will be that which is sufficient to provide a coating having a cross-sectional film thickness of at least about 0.1 micrometer (1,000 Angstroms).

While not to be construed as limiting, the following mechanistic descriptions are offered as speculative explanation of the success of the preferred halocarbon gases of the present invention. During the plasma etch process of the present invention, the process variables are selected to create conditions favorable for a polymerization reaction of certain gaseous halocarbons of the present invention. In particular when carbon tetrafluoride is the etchant reactive gas one or more of the following reaction is likely to occur:

$$6 CF_4 + 2C ---- 4C_2F_6$$
$$CF_4 + C ---- C_2F_4$$
$$2CF_4 + 4C ---- 2C_3F_4$$

The unsaturated or olefinic tetrafluoroethylene is a polymeric active monomer and is believed to polymerize under the instant plasma etch conditions to form polytetrafluoroethylene as follows:

$$n CF_2CF_2 ------- [-CF_2CF_2-]_n$$

It is further believed that this classical olefin polymerization addition reaction dominates any other polymer formation mechanisms (ionic polymerization) and accounts for the synthesis of the very adhesive films of the present invention. While this description has been made for the reactive halocarbon gas carbon tetrafluoride ($CF_4$), the same reasoning exists for the other halocarbon gases listed above; that is, an unsaturated halocarbon monomer is either present as the reactive gas, i.e. ethylene tetrafluoride ($C_2F_4$), or an unsaturated halocarbon monomer is created by the plasma environment thereby causing active polymerization of the unsaturated organic molecule.

Oxygen and boron trichloride can be added to the chamber in lieu of or along with nitrogen. Depending on the amounts of these gases and the plasma etch conditions applied, this can result in the formation of oxygenated and nitrogenated halogenated polymers of varied characteristics. Because the present plasma etch process causes olefin polymerization and creates thermodynamic conditions encouraging the dissociation of any inorganic molecules, any polymer product will likely be a composite inorganic-organic polymer. During catenation of the organic halocarbon in the plasma environment, the copolymerization with inorganic molecules or ions (oxygen or nitrogen) can occur in the following manner.

$$n CF_2CF_2 + O_2 -------- [-OCF_2CF_2OCF_2CF_2O-]_n$$

Consequently, selection of input gases and control of the plasma etch process conditions within the parameters of this invention will result in the superlatively adhesive film coating disclosed herein. One critical condition of control to achieve the instant chamber film coating is the absence of hydrogen from the plasma reaction to achieve long chain polymerization of the halocarbon; i.e. the hydrogen acts as a polymer chain terminator. Additionally, the presence of other organic materials in the chamber such as an organic photoresist on the target source will alter the ultimate makeup, and consequently the characteristics, of the polymer coating deposited on the chamber walls.

In the course of continuous etching without concurrent film formation, the surface of the instant contaminant trapping polymeric coating degrades over time and the plasma coating forming process has to be repeated at least periodically. When etch chamber 110 surfaces are coated concurrently while the workpiece surface is being etched, portions of the coating surface which are eroded due to plasma bombardment are constantly repaired by the deposition of new polymeric material. A disadvantage of this concurrent coat/etch technique is that the plasma process variables must be carefully controlled so as to avoid deposition of even minor amounts of polymer upon the workpiece surface. Thus, even though use of a separate coating deposition step periodically between etch steps or runs may consume some potential processing time in the etch chamber, there is less possibility of polymeric coating interfering with the etch process.

## EXAMPLES

The following examples demonstrate the plasma formation of the particulate entrapping coating on the inner walls of a plasma chamber in the practice of the present invention.

### EXAMPLE 1

In actual practice of the present process of forming a film on the inner walls of a plasma reaction chamber, there is provided a workpiece comprised of a solid wafer of photoresist comprised of a phenol formaldehyde novalak resin with a diazoquinone sensitizer. A glow discharge plasma environment is created utilizing $BCl_3$, $Cl_2$, and $N_2$ gases each flowing at approximately 50 sccm. The power applied ranges between 500 to 800 W, the process chamber pressure ranges from about 200 to 600 mT, the operational workpiece temperature is about 80°C, and the chamber wall temperature is maintained at 65 degrees Centigrade. The power is applied for three minutes and thereafter there is observed a solid film coating of approximately 0.2(2,000 Angstroms) micrometers throughout the chamber.

### EXAMPLE 2

The above example is repeated except that the workpiece to be etched is a silicon wafer overlaid with an aluminum layer which is further overlaid with a patterned photoresist comprised of a Shipley 1400-33 photoresist. Additionally, the organic gas, methane ($CH_4$), is communicated to the chamber at about 50 sccm along with three etchant gases, $BCl_3$, $Cl_2$, and $N_2$. The plasma power is applied in the same amounts and the temperatures are maintained in a comparable manner as outlined in Example 1. The pressure of the chamber is intermittently lowered to 300mT and subsequently increased to 500mT over the period of 4 minutes required to etch the workpiece. After the etching of the wafer has been completed, a coating of approximately 0.2 micrometers is observed throughout the chamber including the gas distribution plate.

### EXAMPLE 3

Etching of the workpiece of Example 2 is repeated except that the etch gases further comprise trifluoromethane ($CHF_3$) instead of methane ($CH_4$) gas, the total flow of the gases being 150 sccm; the power density applied being 400 W; the process chamber pressure being varied intermittently between 300mT and 500mT; and the operational workpiece temperature being varied between 65°C and 80°C, the chamber wall being maintained at 65°C. Etching and film deposition were carried out for 2 minutes resulting in a 0.2 micrometer layer of fluorocarbon polymer on the inner walls of the chamber.

### EXAMPLE 4

This Example illustrates the effect of manipulating the plasma process variables of (1) the compositional makeup of the plasma generating gases, (2) the process chamber pressure, and (3) the RF power to achieve the instant plasma generated polymeric coatings of plasma chamber walls. In this Example, the chamber wall was maintained at a constant temperature of 80°C. The carbon containing material used within the chamber was an 8 inch diameter silicon wafer having its upper, exposed surface coated with Shipley 1400-33 photoresist. This photoresist is composed of 33 percent solids prior to spin and bake, with at least 98% of the solvent carrier being removed during bake. The photoresist resin is a novolak phenol formaldehyde, the sensitizer is a diazoquinone, and the solvent is cellosolve acetate (80%), N-butyl acetate (10%) and xylene (10%).

Table 1, below, demonstrates the effect of changing the cited plasma process parameters on plasma generated polymer deposition. If heavy polymer deposition was observed from the etch chamber window, the process was terminated after 10 minutes. Otherwise, the process was terminated after 15 minutes.

## TABLE 1

| BCl$_3$ (sccm) | Cl$_2$ (sccm) | N$_2$ (sccm) | Power (W) | Pressure (mT) | Polymer on Lid | Polymer on Body | Polymer on Kit* |
|---|---|---|---|---|---|---|---|
| 0 | 200 | 0 | 800 | 600 | no | no | no |
| 0 | 80 | 0 | 800 | 200 | no | very light[1] | no |
| 0 | 200 | 0 | 500 | 50 | no | no | light |
| 50 | 50 | 50 | 800 | 200 | very heavy[2] | very heavy[2] | very heavy[2] |
| 50 | 50 | 50 | 800 | 600 | very heavy[2] | very heavy[2] | very heavy[2] |
| 50 | 50 | 0 | 800 | 200 | light[3] | light[3] | light[3] |
| 50 | 50 | 0 | 800 | 600 | no | no | no |
| 0 | 50 | 50 | 800 | 200 | light[4] | light[3] | light[4] |
| 0 | 80 | 20 | 800 | 200 | light[4] | light[4] | light[4] |
| 0 | 200 | 20 | 800 | 600 | no | no | no |
| 0 | 200 | 20 | 500 | 50 | no | no | light |

[1] The material deposited on the chamber walls could not be visually observed. Presence of the deposit was determined by wiping the chamber with water; a slight yellow stain was found on the wet wiping cloth.

[2] The deposited material was transparent in color and did not flake. The polymer could be removed with a water wipe.

[3] The material deposited was white or gray in color and could be removed with a water wipe or an isopropyl alcohol wipe. The polymer appeared to be more soluble in isopropyl alcohol.

[4] The material deposited could be removed by wiping with water or isopropyl alcohol.

* A ceramic insert (kit) was used over the surface of portions of the chamber wall

Based on the data of Table 1, it appears preferable to use N$_2$ as a constituent gas in combination with the carbon containing material to promote polymer formation. Cl$_2$ generally militates against polymer formation and should be used to lessen or minimize film formation. Note that if either BCl$_3$ or N$_2$ were added to the Cl$_2$, a light deposition appeared at certain process pressures. If BCl$_3$ and N$_2$ were both used in combination with Cl$_2$, the polymer formation could be heavy. When the plasma was generated from Cl$_2$/BCl$_3$ or Cl$_2$/N$_2$, the film deposition occurred only at the lower operational pressure (about 200 mT). The data clearly establishes that lower pressures enhance polymer formation.

The above experimental data indicates that employing different carbon-containing coating-forming gases and etchant gases in plasma etch processes while controlling the previously specified process parameters makes it possible to obtain acceptable etch rates while coating etch chamber walls with a polymeric coating which traps particulate contaminants.

Having described the invention, it will be apparent to those skilled in the art that various modifications can be made within the scope of the present invention. For example, the process configuration of Figure 1 is exemplary and other plasma devices and chambers can be used. The power level is not critical and is readily determined empirically for the mix of gases, chamber pressures and temperatures necessary for the deposition of the instant chamber film coating.

**Claims**

1. A method for coating a plasma etch chamber to secure plasma generated particulate by-products to the chamber wall comprising:

   a) providing a plasma etch chamber having a workpiece pedestal and plasma generated particulate residues attached to the inner walls thereof;

   b) communicating into the chamber at least one carbon containing material which volatilizes under plasma glow discharge conditions;

   c) activating a plasma within the plasma etch chamber; and

   d) maintaining the chamber at a pressure between 100 to 700 mTorr and the temperature of the workpiece pedestal higher than the chamber walls for a sufficient period to cause polymerization of the carbon containing material and deposition of a surface coating of the inner walls of the chamber in a layer having a thickness of at least 0.1 micrometer (1,000 Angstroms) whereby an interpenetrating network of polymer film is formed about the accumulated contaminant particles thereby entrapping the particulate contaminants and rendering the plasma chamber contaminant free for further etch processing use.

2. The method cf Claim 1 wherein the carbon containing material is organic photoresist.

3. The method of claim 1 wherein the carbon containing materials are alkane, alkene, or halocarbon gases.

4. The method of Claim 3 wherein the carbon containing materials are halocarbon gases selected from the group consisting essentially of trichloromethane ($CHCl_3$), tetrafluoromethane ($CF_4$), difluoromethane ($CH_2F_2$), trifluoromethane ($CHF_3$), tetrafluoroethylene ($C_2F_4$), perfluoropropane ($C_3F_8$), and chlorotrifluoromethane ($ClCF_3$).

5. A method for controlling plasma generated particulate by-product buildup on the inner walls of a plasma reaction chamber during the plasma etching of a metallic film workpiece comprising the steps of:

   a) providing a plasma etch chamber;

   b) communicating into said chamber at least one etchant gas and at least one carbon-containing gas;

   c) activating a plasma within the plasma etch chamber; and

   d) manipulating the plasma process conditions so as to effect concurrent and continuous etching of the workpiece and film formation on the inner walls of the chamber whereby an interpenetrating network of polymer film entraps and encapsulates plasma generated particulate contaminants to secure them to the inner wall surface.

6. The method of Claim 5 wherein the plasma process conditions are changed to reduce etching and increase film deposition on the chamber walls.

7. The method of Claim 6 wherein $N_2$ and $Cl_2$ are additionally communicated into the chamber.

8. The method of Claim 6 wherein the pressure is reduced from 500mT to 300mT and the workpiece pedestal temperature is raised above the temperature of the chamber wall to effect a chamber differential of at least 5°C.

9. The method of Claim 5 wherein the carbon containing gas is selected from the group consisting of alkane, alkene or halocarbon gases.

10. The method of Claim 5, wherein the carbon containing gas is selected from the group consisting essentially of trichloromethane ($CHCl_3$), tetrafluoromethane ($CF_4$), difluoromethane ($CH_2F_2$), trifluoromethane ($CHF_3$), tetrafluoroethylene ($C_2F_4$), perfluoropropane ($C_3F_8$), and chlorotrifluoromethane ($ClCF_3$).

11. The method of Claim 5 wherein the etchant gases is the carbon containing gas.

12. The method of Claim 5 wherein the temperature of the workpiece pedestal is maintained between about 60 °C and 70°C.

13. The method of Claim 5, wherein said activated plasma exhibits a power density ranging from about 300W to about 800W.

14. The method of Claim 5, wherein a polymeric film having a thickness of at least 0.1 micrometer is formed on said etch chamber wall.

15. In an apparatus for plasma etching workpieces comprising a chamber; a source of polymeric film forming gas and means for admitting such gas into said etch chamber; and an electromagnetic energy source electrically coupled to an electrode in said chamber to generate a plasma therein; the improvement comprising a particulate contaminant trapping coating of at least 0.1 micrometer thickness formed on the inner surfaces of said chamber by plasma polymerization of a halocarbon gas selected from the group consisting essentially of trichloromethane ($CHCl_3$), tetrafluoromethane ($CF_4$), difluoromethane ($CH_2F_2$), trifluoromethane ($CHF_3$), tetrafluoroethylene ($C_2F_4$), perfluoropropane ($C_3F_8$), and chlorotrifluoromethane ($ClCF_3$).

16. The apparatus of Claim 15 wherein the particulate trapping coating is formed by the plasma polymerization of the halocarbon gas in the presence of one or more inorganic gases.

17. The apparatus of Claim 16 wherein the inorganic gases are a mixture of $N_2$ and $Cl_2$.

FIG. 1

FIG. 2

| European Patent Office | **EUROPEAN SEARCH REPORT** | Application Number EP 94 30 7139 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X,D | US-A-5 085 727 (STEGER) <br> * column 4, line 3 - line 59; claims 1-6 * | 15 | C23C16/26 <br> C23F4/00 <br> H01L21/00 |
| Y,D | | 1,3,4 | |
| Y | US-A-5 221 414 (LANGLEY ET AL.) <br> * column 3, line 50 - column 4, line 4; claim 1 * | 1,3,4 | |
| A,D | US-A-4 372 807 (VOSSEN JR. ET AL.) <br> * claims 1-7 * | 5-14 | |
| | | | **TECHNICAL FIELDS SEARCHED (Int.Cl.6)** <br><br> C23C |

The present search report has been drawn up for all claims

| Place of search | Date of completion of the search | Examiner |
|---|---|---|
| THE HAGUE | 23 January 1995 | Patterson, A |

EPO FORM 1503 03.82 (P04C01)

14